# EUROPEAN PATENT APPLICATION

(11) **EP 2 703 715 A1**
(43) Date of publication of application: **05.03.2014**
(21) Application number: 11863760.2
(22) Date of filing: 26.10.2011
(51) Int. Cl.: F23G 5/16, F23G 5/00, F23G 5/04, F23G 5/44, F23L 9/02

(54) **COMBUSTION DEVICE, COMBUSTION METHOD, AND ELECTRIC POWER-GENERATING DEVICE AND ELECTRIC POWER-GENERATING METHOD USING SAME**

(30) Priority: 19.04.2011 JP 2011092979; 13.07.2011 JP 2011155280
(71) Applicant: Hokkaido Tokushushiryou Kabushikikaisha, Hokkaido 060-0013 (JP)
(72) Inventor: ONOSE Kazuhiro, Kamikawa-gun Hokkaido 089-0101 (JP)
(74) Representative: De Groote, Christophe
(86) International application number: PCT/JP2011/074723
(87) International publication number: WO 2012/144101

(57) **Abstract**

[Problem] To provide a combustion device of high combustion efficiency in which additional charging of combus - tion material containing solids is also possible, and an electric power-generating device using same. [Solution] The combustion method that burns combustion material inside a combustion device comprises: a process of charging the combustion material in the combustion chamber of the combustion device; a process of igniting and burning said combustion material; a process of supplying air or combustion-aiding gas (called "air, etc." below) to the flame resulting from the combustion of said combustion material from outside of the flame; a process of secondary combustion of the combustion material by said air, etc.; and a process of smoke exhaus - tion; and in particular, comprises a process of additionally charging combustion material that at least contains solids into said combustion chamber during combustion of the combustion material.

## Description

### Technical Field

The present invention relates to a combustion device and combustion method, and an electric power-generating device and electric power-generating method using same, and particularly relates to techniques for improving combustion efficiency and electric power generation efficiency.

### Background Technology

The invention of the high temperature endurance thermoelectric power generation module disclosed in Patent No. 4457215 enables an electric power generating device to be formed out of a part or all of a combustion chamber with the thermoelectric power generation module, and enables efficient electric power generation using the same heat source for thermoelectric power generation using the heat of combustion and without reducing thermal energy by generating electricity using steam turbines.

The combustion chamber disclosed in Patent No. 3318748 is formed in a cylindrical shape, and air for combustion is continuously supplied to a flame from outside the flame and circulated to match the advancing of the flame so as to expand the combustion area in the advancing direction of the flame and thereby prevent degradation due to partial overheating of the electric power generation module that forms the combustion chamber.

Using a material that can be red-hot as a partition providing a flame through means in the combustion chamber promotes combustion which preventing reduction in combustion temperature, and using a pipe material that has a thermoelectric power generation function disclosed in Patent No. 3318748 enables steam to be generated while generating electrical power.

In a combustion device that burns by circulating air, an induced airflow is generated into the combustion chamber by a partial negative pressure using wind directional plates in the combustion chamber with a solid fuel inlet to enable continuous input of solid fuel conventionally not possible.

In secondary combustion, continuously supplying air for combustion to a flame while repeatedly alternating from outside the flame and from behind the advancing direction of the flame for natural air intake using the negative pressure generated by the airflow that accompanies burning enables complete combustion of combustible waste that includes miscellaneous materials.

Repeatedly conveying an airflow from a lower part to an upper part of a drying tank on objects to be dried and supplying air from below to float while stirring combustible waste containing miscellaneous materials in a drying tank in an airflow drying device that uses the drying method disclosed in Patent No. 4221617 enables stable combustion and electric power generation to be secured while preventing temporary drops in combustion temperature in air drying that utilizes exhaust heat of waste steam of a steam turbine electric power generating device by increasing opportunity and area for contacting air.

Incorporating the exhaust discharged from the airflow drying device into the air for combustion of the combustion device enables odors to be eliminated by combusting the exhaust at a high temperature.

In the secondary combustion, complete combustion is possible by utilizing the exhaust of the combustion device that uses combustible waste including miscellaneous materials as fuel as a part of the combustion air of the combustion device that uses liquid fuel with high viscosity such as waste oil as fuel, and also the waste oil with high viscosity or the like can be utilized as fuel by utilizing exhaust heat of the combustion device that uses the combustible waste as fuel.

Meanwhile, Japanese Patent Publication No. H11-83022, Japanese Patent Publication No. 2000-257834, Japanese Patent Publication No. 2001-141245, Japanese Patent Publication No. 2009-144938, and the like have disclosed rotation combustion devices using liquid fuel or the like, and particularly, excellent combustion efficiency in a capacity test of the device disclosed in Japanese Patent Publication No. 2001-141245 has been well known.

An electric power generating device that forms a part or all of the combustion chamber by a thermoelectric power generation module with high temperature endurance as disclosed in Japanese Patent No. 4457215 becomes possible by utilizing combustion energy obtained in the rotary device, and also electric power generation with excellent energy efficiency becomes possible by carrying out electric power generation using both thermoelectric power generation and thermal energy simultaneously without reducing the thermal energy that uses the same heat source.

As for countermeasures to the generation of hazardous substances and smoke exhaustion due to incomplete combustion of a naturally aspirated combustion device that uses waste of paper products, wooden products, or the like, and waste oil from automobile, machinery, food processing, or the like as fuel, Japanese Patent No. 138656 proposes a combustion promotion plate and Japanese Unexamined Patent Application Publication No. 2007-242168 proposes a circulating system in a waste oil combustion device.

Further, Japanese Patent No. 3066066 proposes a combustion device having a feature to promote combustion by providing a combustion promotion plate in the furnace to retain the air within the furnace longer at a high temperature, and Japanese Patent No. 3318748 proposes a petroleum product rotation combustion stove having a feature to have a secondary combustion peripheral to the furnace by supplying and rotating air using a blower to generate rotation combustion.

Many incinerators for waste have been proposed that require a large amount of air when burning plastic pieces or the like, and the majority of these are large-scale facilities requiring a high initial investment making it difficult for adoption by small businesses due to the increased running cost necessary for kerosene or other fuels for secondary combustion.

### Prior Art Documents

### Patent Documents

Patent Document 1: Japanese Patent No. 4457215
Patent Document 2: Japanese Patent No. 3318748
Patent Document 3: Japanese Patent No. 4221617
Patent Document 4: Japanese Unexamined Patent Application Publication No. H11-83022
Patent Document 5: Japanese Unexamined Patent Application Publication No. 2000-257834
Patent Document 6: Japanese Unexamined Patent Application Publication No. 2001-141245
Patent Document 7: Japanese Unexamined Patent Application Publication No. 2009-144938
Patent Document 8: Japanese Patent No. 138656
Patent Document 9: Japanese Patent No. 3066066
Patent Document 10: Japanese Unexamined Patent Application Publication No. 2007-242168

### Summary of the Invention

### Problems to be Solved by the Invention

Examples of convention problems are given below.
(1) A combustion method that supplies air from outside a flame to combust solid fuel still has not been proposed.
(2) A method for continuously introducing solid matter in a combustion method that supplies air from outside a flame has not been proposed.
(3) A method for purifying an exhaust flame when a combustion temperature is low in a combustion method that supplies air from outside a flame has not been proposed.
(4) A method for preventing incomplete combustion due to insufficient air in order to use miscellaneous solid fuel has not been proposed.
(5) A method that forms a part or all of a combustion chamber by a thermoelectric power generation module and generates electric power a temperature difference between the inside and outside of the combustion chamber without reducing thermal energy has not been proposed.
(6) A composite electric power generation method that generates electric power and the like that uses thermal energy and thermoelectric power generation that generates electric power using the same heat source and without reducing the thermal energy.

In a combustion device, increasing combustion efficiency, realizing energy conservation, and increasing durability of a furnace. Particularly when burning material ill-suited to conventional combustion, such as when there is a lot of smoke causing problems as in the case of plastic, the cause of that is because combustion is not preferred. If combustion for this can be improved and the smoke eliminated, then two purposes are fulfilled in one.

To provide, in thermoelectric power generation that uses temperature difference, a method that generates electric power by forming a part or all of a combustion chamber of a thermoelectric power-generating device without reducing thermal energy due to a temperature difference between the inside and outside of the combustion chamber.

To provide an electric power generation system that enables simultaneous electric power generation by thermoelectric power generation and steam turbine using the same heat source of the combustion chamber.

To provide an electric power generation system in which combustible waste including miscellaneous material is used as fuel without separating raw garbage that has a high water content and reduces combustion temperature from petroleum products and the like that require large amounts of air to burn, and that recycles combustible waste by electric power generation via thermoelectric power generation and steam turbines using the same heat source with combustion.

### Means to Solve the Problems

A combustion method for burning combustion material in a combustion chamber including: a step for introducing the combustion material into the combustion chamber of a combustion device, a step for burning by igniting the combustion material, a step for supplying air or a combustion-aiding gas (referred to hereinafter as "air or the like") from outside a flame to the flame in conjunction with combustion of the combustion material, a step for a secondary combustion of the combustion material by the air or the like, and a step for smoke exhaustion.

The configuration may include a step for additionally introducing the combustion material that includes at least a solid content into the combustion chamber during combustion of the combustion material in the combustion method.

The configuration may generate an induced airflow in the combustion chamber in the step for additionally introducing the combustion material in the combustion method.

The configuration may include, in the step for a secondary combustion of the combustion material, a step for supplying air or the like to a flame from the rear of the travel direction of the flame.

The may include, in the combustion method, a step for supplying air or the like to the flame from the outside, and a step for supplying air or the like to the flame from the rear of the travel direction of the flame is alternately repeated.

The configuration may control, in the combustion method, advancing of the flame by a partition having flame through means relative to a progressing flame.

The configuration in the combustion method that dries the combustion material including at least solid content prior to combustion, may include a step for transporting the combustion material to a deposit location, a step for transporting the deposited combustion material from a lower part of the deposit location to an upper part of the deposit location, a step for drying the combustion material at the deposit location and in the transport process, and a step for recovering the dried combustion material and transporting to a combustion chamber.

The configuration, in the step for transporting from a lower part to an upper part of the deposit location, may use air or the like to blow the combustion material upward so as to generate an induced airflow to the outside of the upward blown airflow.

The configuration, in the step for recovering the dried combustion material and transporting to a combustion chamber, may also recover exhaust and the exhaust may be supplied to a combustion device as air for combustion.

A power-generating method, using the combustion method according to any of the above, can be provided by forming part or all of a combustion device by a thermoelectric power generation module and utilizing a temperature difference between the inside and outside of the combustion device generated in the combustion process.

A configuration in a combustion device for burning combustion material may be provided with a combustion chamber formed in a cylinder shape and an air supply opening on the inner side surface of the combustion chamber and cylindrical air injection tubes provided with holes on the inner surface are provided in the advancing direction of a flame.

The configuration may include a partition provided with flame through means inside the combustion chamber.

The configuration may include a combustion material inlet configured of a pipe on the side surface of the combustion chamber and an airflow injection nozzle so as to generate an induced airflow on the inner wall of the pipe.

The configuration may include a secondary combustion chamber of a cylindrical body provided with holes in the side surface having means to incorporate continuous flames in the combustion chamber.

The configuration may include means to incorporate the secondary combustion chamber with air or combustion-aiding gas (hereinafter referred to as "air or the like") from the rear of the advancing direction of flames communicating with the secondary combustion chamber.

The configuration, in the secondary combustion chamber, may include at least two types of secondary combustion chambers with different diameters.

The configuration, in the secondary combustion chamber, may include a cover having a cylindrical body covering the outside to form a space having means to take in air.

The configuration may include a dried object outlet of a drying device provided with a deposition tank having an object to be dried inlet, a circulation inlet, an object to be dried outlet, a dried object outlet, and means for circulating transport from the object to be dried outlet to the circulation inlet, is connected to a combustion inlet of the combustion device.

The configuration may provide a rotary shaft on a drying tank of the drying device, an injection tube provided with holes that promote stirring may be provided near the drying tank of the rotary shaft, plates may be obliquely disposed so as to cover the holes from above the holes of the injection tube, and means for supplying pressure air or the like may be provided on the injection tube.

The configuration may include means for supplying pressure air that provides fan blades driven by a rotary shaft to supply air or the like pressurized by the fan blades into the injection tube.

The configuration may include the rotary shaft divided into an outer shaft and a center shaft, stirring blades, an injection tube, and plates provided on the outer shaft, and fan blades provided on the center shaft.

The configuration, in the drying device, is a configuration in which the object to be dried outlet and the circulation inlet communicate via a circulation duct equipped with blower means, and the circulation duct is provided with an airflow injection nozzle, having supply means of compressed air so as to generate an induced airflow to the outside of the airflow, on the inlet bottom inner wall and curved inner wall of the circulation duct.

The configuration may include a route from an expansion valve of a heat pump to a heat absorbing portion on the outside of the combustion chamber that supplies exhaust heat of the heat pump to the injection tube of air or the like of the combustion chamber by a blower.

The configuration may include an exhaust heat boiler that generates steam using exhaust heat of the combustion chamber and a steam turbine that operates using steam generated by the exhaust heat boiler, wherein a heat exchanger is provided that uses the exhaust heat of the steam discharged from the steam turbine, and warm air or hot air supplied from the heat exchanger is incorporated into the circulation duct.

A configuration that uses the combustion device according to any of claims 11 to 24, may be formed in part or all by a thermoelectric power generation module provided with a plurality of thermoelectric conversion elements continuously formed respectively on opposing surfaces of an inner side of a receptor formed of a material having electrical insulating properties, and that generate electricity by the temperature difference generated at each end.

An electric power-generating system can be provided that includes a combustion device provided with a combustible solid waste cutting machine, an airflow drying device for combustible solid waste, and a secondary combustion device that uses combustible solid waste as fuel, and an electric power-generating device provided with an exhaust heat boiler that uses exhaust heat of the combustion device, a steam turbine electric power generator, and a heat pump; the electric power-generating system forming part or all of the combustion device by a thermoelectric power generation module and effectively using a same heat source for thermoelectric and steam turbine power generators.

### Effect of the Invention

The present invention achieves the following effects.

Incomplete combustion due to insufficient air is eliminated by using negative pressure that occurs due to an increased airflow in conjunction with combustion to continuously and naturally supply air from a lower side taken in from small holes.

A vertical combustion furnace arranged so as to form a series of a plurality of small holes staggered on a lateral circumference increases combustion efficiency by the furnace generating a spiral airflow to increase contact efficiency of air with combustion gas rising on the outside with the flame, and a combustion furnace having a larger diameter than the combustion furnace supplying air from the lower outer side relative to the combustion gas circulating on the outside of the flame.

A high-temperature partition having a plurality of small holes on an inner portion of the combustion furnace heated by a rising flame has an effect of reducing incomplete combustion due to a lowering of combustion temperature.

Durability of the furnace is increased by constructing an optimal combustion structure by mutually overlapping a plurality of the combustion furnaces according to the fuel material, expanding the combustion area in a vertical direction by continuously and repeatedly activating each function, and eliminating localized heating of the furnace interior.

An effective combustion structure characterized by not requiring new power by a natural air intake model can be made even in various combustion devices that have structures that provide an air supply function using a fan or the like.

A combustion structure where a plurality of combustion furnaces provided with small holes on the lateral surface for generating spiral airflow relative to the combustion flame overlap with a plurality of combustion furnaces on the outer sides of the furnace interiors provided with small holes to take in air from the lower side with the combustion gas circulating outside of the furnace interior, is effective regardless of the shape or form provided they have the functions previously described.

Combustion efficiency is increased by generating airflow within the device by providing a cover provided with a plurality of intake ports on the lateral surface of a cylindrical body covering the outer side so as to form a cavity, and by supplying air spirally from the lateral surface relative to the flame so as to efficiently blend the air with the combustion gas circulating outside the flame. Accordingly, it can be understood that an increased smoke removal effect will accompany increased combustion efficiency.

Solid fuel can be safely introduced because the flame extends toward an exhaust port even when a top surface is opened, by exhausting the airflow circulating in the furnace from an exhaust port provided on the lateral surface.

Safety is increased by providing an exhaust port in a cyclone shape in the advancing direction of the circulating airflow. Particularly, safety is further increased by forced exhaustion.

Combustible waste containing miscellaneous elements can be completely combusted by enabling continuous introduction of solid matter in a rotating combustion device and method.

Effective use of energy generated by thermoelectric power generation without reducing thermal energy can be designed using a heat source obtained from a rotating combustion device that uses combustible waste as fuel.

Thermoelectric power generation can be efficiently performed by using a temperature difference between the inside and the outside of a combustion chamber by using a thermoelectric power generation module to form a part or all of the combustion chamber of an electric power-generating device.

Electric power can be efficiently generated using the same heat source by forming a part or all of a combustion chamber of an electric power-generating device by a thermoelectric power generation module to thereby generate thermoelectric power using the combustion heat of the combustion chamber without reducing the thermal energy and to generate electric power by a steam turbine using the combustion heat of the combustion chamber.

The durability of the electric power-generating device can be increased in a combustion chamber by providing a space between an inner wall of the combustion chamber formed by the thermoelectric power generator module and the flame by supplying air from outside of the flame using the air circulating outside the flame, and by enabling the prevention of localized heating by expanding the combustion area in the advancing direction of the flame by continuously supplying air along the advancing of the flame.

Electric power as well as steam can be generated in a combustion chamber by promoting combustion of the combustion gas that advances with the flame and preventing a reduction in combustion temperature by providing a partition in a material that can be heated red hot to control the flame that advances into the combustion chamber, and by providing a pipe material having a thermoelectric power generation function.

An insufficient supply of air during the combustion of combustible waste containing miscellaneous material can be supplemented in secondary combustion by supplying air from outside the flame using natural air intake that uses the negative pressure of the airflow accompanying combustion and by repeatedly supplying air from the rear of the advancing direction of the flame.

Continuous input of solid fuel is possible in a combustion device that supplies air from outside the flame using air circulating outside the flame, by providing wind directional plates and providing an air injection nozzle that generates induced airflow internally in the combustion chamber by using a pipe to form a solid fuel inlet.

Stable and efficient combustion and electric power generation is possible while preventing a drop in combustion temperature by using an airflow drying device to dry combustible waste with high water content in advance.

Drying efficiency is improved an airflow drying device by increasing the opportunity and area for air contact by supplying air from below to float the object to be dried while stirring the object to be dried within a drying tank and by repeated airflow transportation of the object to be dried from the lower portion to the upper portion of the drying tank.

An object to be dried is smoothly circulated in an airflow drying device by providing an air injection nozzle that generates an induced airflow on the outside of the airflow that blows the object to be dried and air upward to a curved inner wall and to an inner wall of a lower portion of an intake port of a circulation duct.

Odors of the combustible waste that is the object to be dried are removed by using the exhaust of the airflow drying device as the air for combustion for the combustion device.

Electric power generation efficiency is increased by using the exhaust heat generated by a heat pump as air for circulation to raise the drying efficiency and by supplying cold air or refrigerant to the outside of the combustion chamber.

More efficient electric power generation is possible by constructing an electric power generation system using combustible waste as fuel provided with an electric power generating device that uses combustible waste as fuel formed by a thermoelectric power generation module, a boiler that generates steam using the heat of combustion of the electric power generating device, a steam turbine electric power generating device that generates electricity using the steam generated by the boiler operation, and a combustible waste airflow drying device; by recycling combustible waste; and by using the same heat source for simultaneous thermoelectric power generation and steam turbine electric power generation.

### Brief Description of the Drawings

[FIG. 1] is an outline diagram illustrating one embodiment of the present invention.
[FIG. 2] illustrates another embodiment of the combustion chamber (primary) of the present invention.
[FIG. 3] illustrates a conceptual diagram of the present invention.
[FIG. 4] illustrates another embodiment of another combustion chamber (primary) of the present invention.
[FIG. 5] is a cross-sectional view illustrating one embodiment of a secondary combustion device of the present invention.
[FIG. 6] is a cross-sectional view illustrating another embodiment of the present invention.
[FIG. 7] is an overall assembly drawing of the present invention.

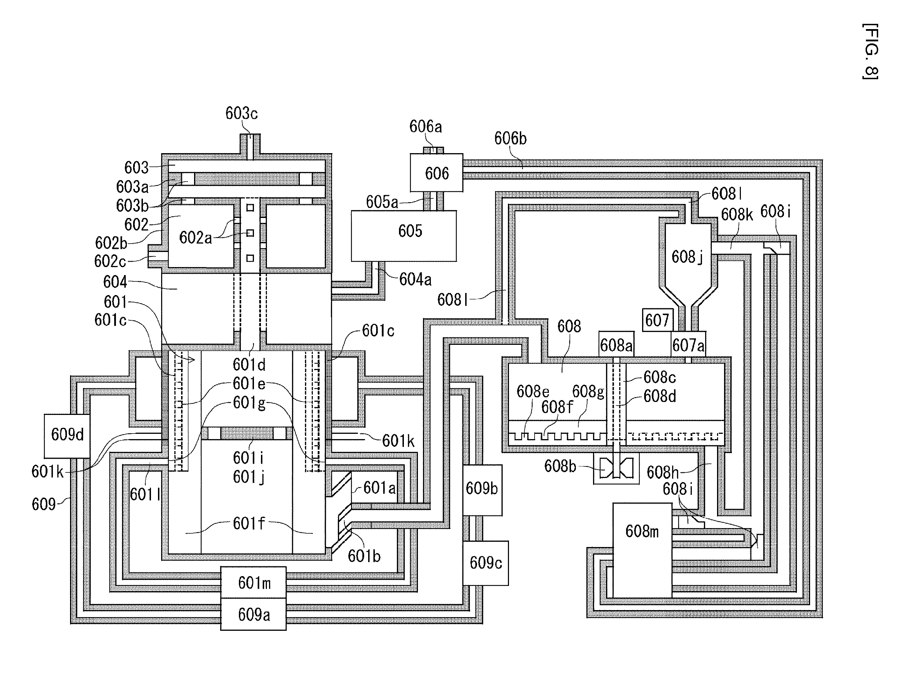

[FIG. 8] illustrates a conceptual diagram of an electric power generating system of one embodiment of the present invention.
[FIG. 9] illustrates an embodiment of when a forced air supply and natural air intake are combined as an air intake method in a combustion chamber.
[FIG. 10] illustrates a different embodiment of same.
[FIG. 11] illustrates a different embodiment of same.
[FIG. 12] illustrates a configuration of a combustion device that introduces combustion material from a top surface (plane side) of the combustion chamber.
[FIG. 13] illustrates a configuration of a combustion device that introduces combustion material from a side surface of the combustion chamber.
[FIG. 14] illustrates a different embodiment of a combustion device that introduces combustion material from a side surface.
[FIG. 15] illustrates a configuration of a combustion device equipped with a secondary combustion device that introduces combustion material from a top surface (plane side) of the combustion chamber.
[FIG. 16] illustrates a different embodiment of same.

### Description of preferred embodiments of the invention

Embodiments of the present invention will be explained below with reference to drawings.

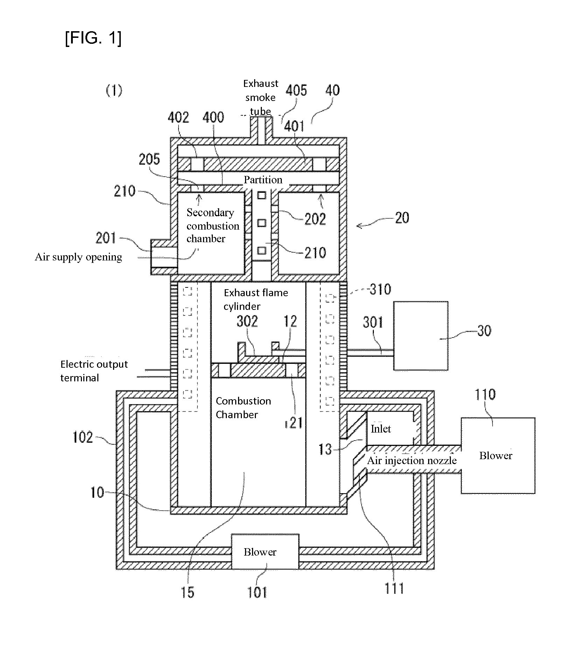

FIG. 1 illustrates a combustion unit (10), a secondary combustion chamber (20), a blowing device (110), and a waste oil tank portion (30), and the like in a combustion device of the present invention.

The combustion device (10), as illustrated in FIG. 1, carries out a combustion process.

There is an inlet (13) for solid matter and other combustion material, and adjacent to this, an air injection nozzle portion (111) is provided to induce the combustion material into a combustion chamber (15).

Note that, in the present invention, any combustion-aiding gas may be used instead of air, but the examples given in the embodiments below use air.

An outside air shielding introduction device provided with an introduction auxiliary chamber (not illustrated) and double entry doors on the outside of the combustion chamber may also be used to reliably and completely introduce solid matter.

In other words, the air injection nozzle portion (111) equipped with holes on the side surface in the advancing direction of a flame is provided to supply continuous air in the advancing direction of the flame from the outside of the flame by air circulating outside of the flame.

Therefore, air is injected along the flame and waste and other solid matter is introduced thereby enabling continuous introduction without interfering with the flame.

In the drawing, the inlet (13) is on the upper side of the air injection nozzle (111), and solid matter is lifted up from below to benefit the area around the fire.

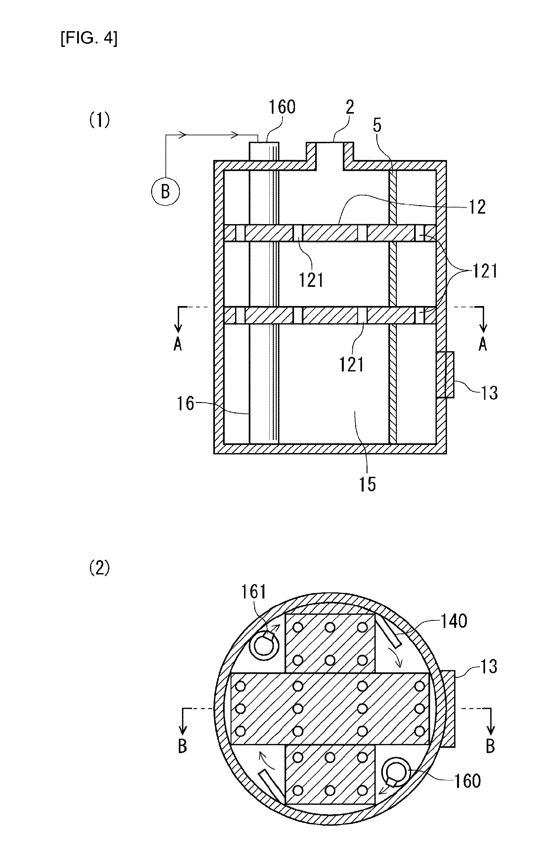

Further, it can be understood from a cross-sectional shape of the combustion chamber (15) that a circular shape, as illustrated in FIG. 4 is preferred for good flow.

In addition, the inlet is formed in a cylindrical shape so as to communicate with the combustion chamber, and continuous introduction of solid matter is made possible by providing the air injection nozzle (111) that generates an induced air flow into the interior of the combustion chamber.

The inlet (13) is for introducing solid combustion fuel and the like for combustion here together with igniting.

An ignition burner may be permanently established there to ignite the solid matter before sending through the inlet (13) for combustion.

Because the inlet (13) and the air injection nozzle (111) are slanted and provided in parallel, introduction of the solid waste can be carried out smoothly and when arranging and a tangential direction so as to generate a swirling flow relative to the combustion chamber (15), as illustrated in (2) of FIG. 1, it can be understood to be formed even better, and the solid matter can be continuously introduced by the swirling flow.

The combustion chamber (15) provided in the combustion device (10) is configured so that air swirls.

To do so, wind directional plates (140) are provided slanted relative to a blow outlet (130) into the combustion chamber (15) so as to generate, for example, an appropriate number of swirls. A chamber for a hole (130) of the blow outlet of air entered from the inlet (13) is surrounded by four corners, but, as illustrated in FIG. 4, it may be a circular tube.

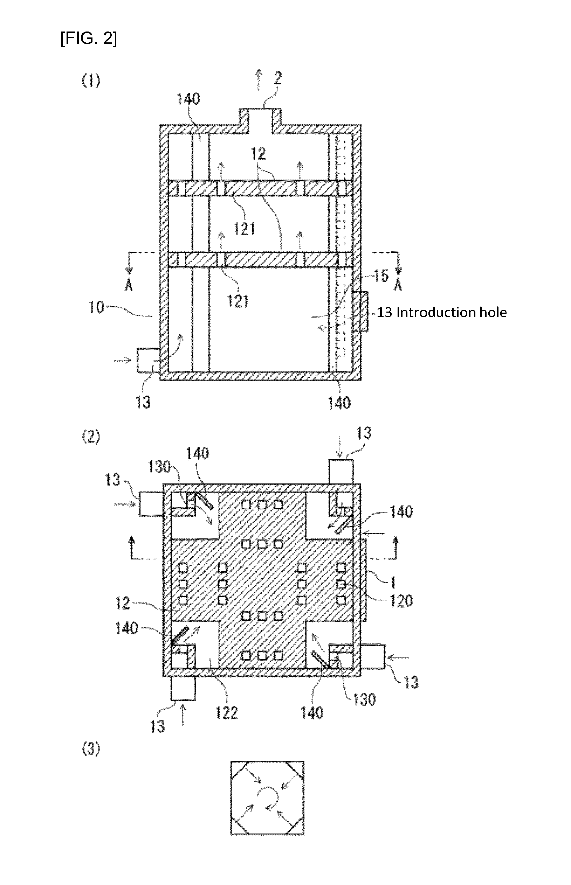

In the example illustrated in (2) of FIG. 2, it can be seen that the wind directional plates (140) are provided in the corner sections of the combustion chamber (15). As illustrated in (2) of FIG. 2, the flow that enters from the inlet (13) is discharged from the hole (130), but the wind directional plates (140) are slanted relative to the introduction direction for the discharge direction, and therefore, the combustion gas is deflected to be given a swirling component so that a swirling airflow is generated when the center of the combustion chamber (15).

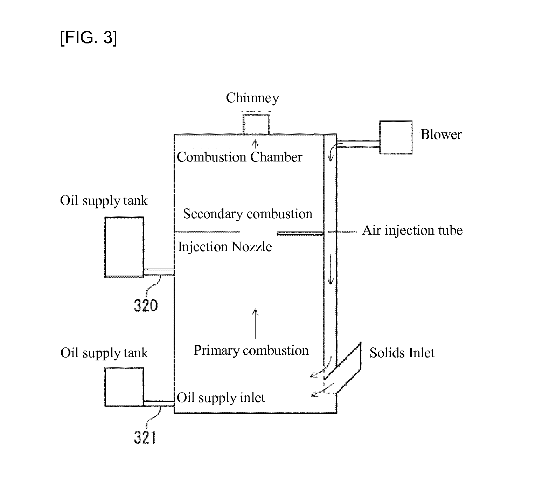

As illustrated in FIG. 3, providing a fuel injection nozzle (320) that communicates from a liquid refueling tank inside a liquid combustion chamber (15) may be considered instead of the solid fuel. For example, arranging the fuel injection nozzle (320) in the inlet (13) and supplying the liquid and gas fuel from a tangential direction to the flame allows a swirling airflow to be supplied to the flame from outside of the flame to further promote combustion. By spraying with the fuel injection nozzle (320) in the swirling flow (meaning no right angles), it can be understood that the fuel can be smoothly promoted without going against the swirling flow.

Of course, the fuel injection nozzle may be provided on the inlet (13), and in such case, it is sprayed on the flame from the outside of the solid matter.

Further, providing a combustion nozzle (321) on a lower end of the combustion chamber for combustion using liquid fuel allows the introduced solid matter, from the inlet (13), to be combusted instead of the solid fuel. This nozzle may also be provided along the swirling flow. When using petroleum products or the like as liquid fuel, large amounts of air for fueling is used, so lengthening the progression direction of the combustion chamber (furnace) in a rotating combustion device allows space for maintaining complete combustion.

When it is impossible to increase the size of the combustion chamber, this can be resolved by providing a plurality of exhaust smoke tubes (210) described hereafter to supply air from the outside.

Furthermore, when using fuel having a high moisture content, consideration may be given to implementing secondary combustion using additional liquid or gas fuel in the air injection nozzle or the like, and a combustion dish with high viscosity for waste oils and the like to be described hereafter may be provided.

Alternatively, drying in advance using an airflow drying device may also be considered.

Further, providing the air blow outlets (130) in four locations in the corners allows for the generation of stronger swirling flow. Wind directional plates (140) are provided to facilitate formation of the swirling flow. As illustrated in (2) of FIG. 2, it can be understood that the wind directional plates (140) facilitate swirling because the respective wind directions thereof are mutually offset from center as illustrated in (3) of FIG. 2.

Further, an opening (122) is provided in each of the four corners for a rising outlet of the swirling flow. However, four locations are not required for shaping the swirling flow, but when considering symmetry, four locations are favorable for production.

Note that, as illustrated in (3) of FIG. 2, the corner may be cut diagonally to provide blowing. In this case, production becomes easier.

The combustion airflow given a swirl component rises, but it directly hits a partition plate (12) above changing the flow in a 90° direction.

Accordingly, the partition plate (12) is kept warm, so this brings an advantageous effect that does not allow the combustion temperature to drop relative to the airflow. Particularly, a further advantageous effect can be obtained by making the material red hot. The flow along the partition plate (12) rises from an opening (122) provided in a corner or corners, during which, sufficient combustion time is given.

As another embodiment, the partition plate (12) may be provided in plurality as necessary as illustrated in FIG. 2 or FIG. 4, and further, a plurality of small holes is suitably drilled in the partition plate (12), and these small holes (121) are provided so as to generate an air flow in the same direction along the inner wall of the combustion chamber (15).

Accordingly, if these small holes (121) are drilled so as to incline in the direction that airflow is generated, it further contributes to the generation.

As an alternative example of the combustion chamber (10), the cylinder is provided as a circular cross-section as illustrated in FIG. 4. When the cross-section is circular, the swirl flow can be favorably formed.

In this example, the partition plates (12) are staggered. The air injection tube (160) passes through the combustion chamber (15), and because an injection port (161) is provided for air in the axial direction along the plurality of tubes, the combustion air can be sufficiently supplied. Obviously, the direction of the injection tube is provided so as to easily form the swirling flow in the circumferential direction, and because a wind directional plate (140) is provided at the tip thereof, it can be understood that swirling becomes even easier to form. The air injection tube (16) can be supplied from an external blower.

When combusting a solid material in this manner, the air can be supplied sufficiently and smoothly without reducing the combustion temperature, and sufficient combustion time can be given by the swirling flow so that continuous feeding is possible for even solid materials. Note that a cross-section of the combustion chamber (15) was a square in the example illustrated in FIG. 2; however, it may also be in the form of a circle, rectangle, or other shape.

As illustrated in FIG. 1, storing a waste oil combustion tray (302) above the partition plate (15) allows the waste oil to be easily combusted, and this enables a further increase in the combustion temperature. Of course, this is not limited to waste oil, and normal fuel oil may be brought in.

A waste oil tank (30) may be provided externally to enable supply through a feed oil tube (301).

Further providing a thermoelectric power generating element (310) on the periphery of the combustion chamber (15) is advantageous to generating electric power.

Providing the electric power generating device that utilizes thermal energy to the rotation combustion device enables the electric power generation that uses both thermoelectric power generation and thermal energy that generate electric power by the same heat source without reducing the thermal energy.

The combustion airflow further rises and enters a secondary combustion chamber (20). There is an exhaust flame section (210) in the combustion chamber (20), and providing the exhaust flame section (210) that alternates air supply from the rear of the flame advancing direction and the outside of the naturally aspirated flame utilizing negative pressure of airflow generated by the advancing of flames enables prevention of incomplete combustion due to insufficient combustion air.

That is, in the exhaust flame section (210), a hole (202) aspirated by ascending airflow is provided on the circumference of the side surface of a vaulting box (210), and the combustion can be nearly complete by aspirating external air from the outside. The holes (202) are provided, for example, in the axial direction every 90 degrees on the side surface, and it is preferred to provide a plurality of holes (202) in a staggered arrangement to one another so as to not interfere with aspiration.

A cover (2) is provided around the exhaust flame section (210) so as to enclose the surroundings. Consequently, the flow is smooth and efficiently aspirated into the exhaust flame section (210). The air flow from the exhaust flame section (210) rises and enters into a combustion promotion section (40).

A portion aspirated from an inlet (201) passes through the hole (205) in a top panel (400) to aspirate into the airflow and supply fresh oxygen into the airflow within the exhaust flame cylinder (210). The airflow is directly aspirated into the holes in the partition plate (401) above the hole (205) and moves to an outlet (405) by changing the direction 90 degrees.

In short, a sufficient combustion time can be gained by meandering.

When providing the partition plate (401) in the exhaust flame section (210), the ascending airflow that can further increase the combustion efficiency is turned 90 degrees by the partition plate (401) and flows to increase the combustion temperature by controlling and retaining the advancing of the flame. It is desired that the hole (205) of the top panel (400) and the hole (402) of the partition plate (401) do not match, in other words, they are placed offset from each other rather than communicating on account of combustion time.

Accordingly, it can be understood that the secondary combustion chamber provides a mechanism for carrying out complete combustion.

Furthermore, providing the electric power generating device that utilizes thermal energy in the rotation combustion device enables thermoelectric power generation that generates electric power without reducing the thermal energy, and using thermal energy to turn a steam turbine for electric power generation to be conducted at the same time by the same heat source.

### (Another Embodiment)

In addition to the combustion device described above, the following combustion furnace may be used as the secondary combustion device.

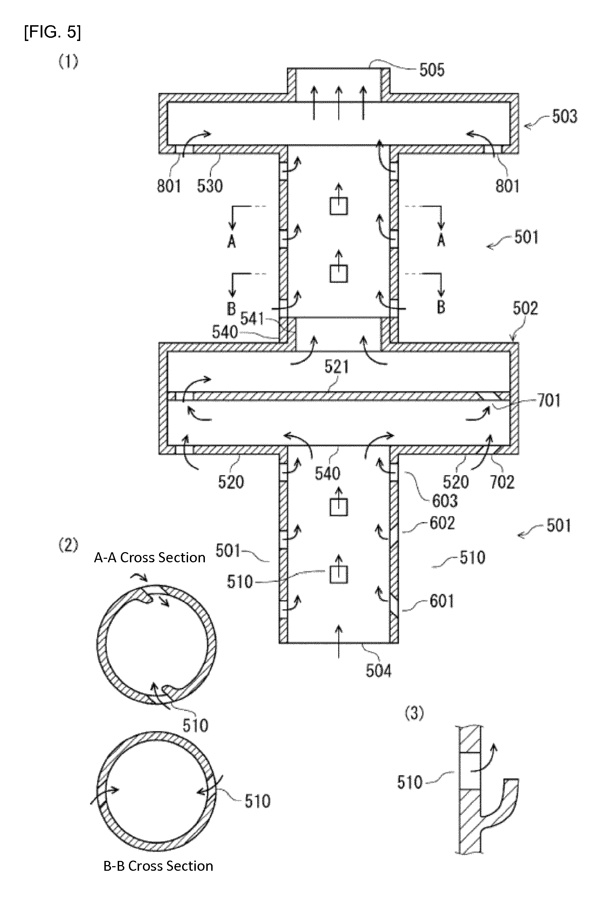

As illustrated in FIG. 5, combustion furnaces (501) to (503) of the present invention are placed above the combustion chamber (15). FIG. 5 illustrates providing the cylindrical combustion furnace (501) that is vertically long and made of an incombustible material, and further provides the combustion furnace (502) thereabove. Small holes (510) are provided in the combustion furnace (501) so as to be provided in the perpendicular direction and circumferential direction in a staggered arrangement to one another.

As illustrated by (2) and (3) in FIG. 5, two holes are provided so as to face each other in a cross section in this embodiment, and two small holes are each arranged so as to face each other vertically in a 180 degree direction.

Accordingly, as illustrated in FIG. 5, as can be seen in the side surface, they are arranged so as to be staggered.

These small holes are for aspirating external air, and the staggered arrangement is preferred for causing the swirling flow.

The combustion furnace (502) is arranged successive to the cylindrical combustion furnace (501) that is vertically long where a plurality of small holes (506) is arranged so as to be staggered on the side peripheral surface.

The combustion furnace (502) is a cylindrical shape with a wider inner diameter than that of the combustion furnace (501), is provided with a partition plate (520) inside having a plurality of small holes in the perpendicular direction, and communicates with the combustion furnace (501).

That is, an opening (540) of the combustion furnace (501) and the opening of the combustion furnace (502) are connected, and when the flame rises, as illustrated in (1) of FIG. 5, it is bent in the horizontal direction, passes through the opening (802) opened in the edge of the partition plate (520) and bends in a horizontal direction, then it changes in a 180 degree direction to flow in the horizontal direction again and goes toward the opening (505) of the combustion furnace (501).

This partition plate (3) may be provided with a slit if necessary in the side surface of the combustion furnace (2) so as to allow removal or insertion to allow putting in and taking out.

That is, continuously supplying air from the side surface in accordance with rising flames to keep the combustion length and time for a long period of time promotes combustion and at the same time the conventional problem where one portion protruding into the furnace is overheated can be eliminated.

Small holes (801) are also provided in the combustion furnace (502) in the bottom panel (530). The positions are preferably in a place where outside air can be taken in; however, it is favorable to place the flame near the opening (802) where it can receive air.

Further, another combustion furnace (503) is provided in an upper part of the combustion furnace (501) illustrated in (1) of FIG. 5. There is simply no partition plate (520) in this example, and the focus is placed on the point to let in outside air. An opening (801) is provided on an edge of the bottom part (530) to let in the outside air. Linking of the combustion furnace (501) and the combustion furnaces (502) and (503) may be done by welding, and as illustrated in (501) of FIG. 5, it can be easily fixed by inserting joints (540) and (541).

In this manner, the combustion furnace can be made up of the combustion furnace (501) and the combustion furnace (502) alternately overlaid or by combining with the combustion furnace (503).

In other words, a cross section diagram illustrating a structure of the combustion device overlaying the combustion furnace (501) and the combustion furnace (502) alternately provided with an exhaust port (505) on the upper part and a flame through port (504) on the lower part.

The combustion furnace (501) uses negative pressure caused by upward airflow for the rising flame accompanied by combustion gas and passes through the flame through port (505) after being ignited by various combustion devices to supply air taken in from the small holes (510) and (520) and the like in a spiral shape from outside of the flame, and the combustion furnace (502) supplies air introduced from the small holes (510) that are arranged at equal intervals at the outermost bottom of the bottom surface of the combustion furnace (502), and the full length of the outer periphery for the flame spreads outward having a wider inner diameter than that of the combustion furnace (501) so that the combustion efficiency is increased.

Accordingly, it may also be considered that the directions of the small holes and openings may be inclined to promote the spiral flow.

As illustrated in the lower section of (501) in FIG. 1, small holes (601) are opened inclining upward. In contrast, small holes (602) are provided inclining downward in the opposite direction. In this case, a whirlpool occurs to provide a stirring effect.

Likewise, the combustion furnaces (502) and (503) may be provided with openings (701), (702), and (801) to be inclined. As illustrated in the cross-sections A-A and B-B of the combustion furnace (501) in (2) of FIG. 5, inclining is provided so as to enable the spiral flow to be reinforced. Of course, inclining can also be provided in the direction to reinforce the spiral flow in the combustion furnaces (502) and (503).

Furthermore, it is understood that providing spiral steps on the periphery of the combustion furnace (501) as spiral formation means is even more beneficial to the formation of the spiral flow by assisting the spiral flow.

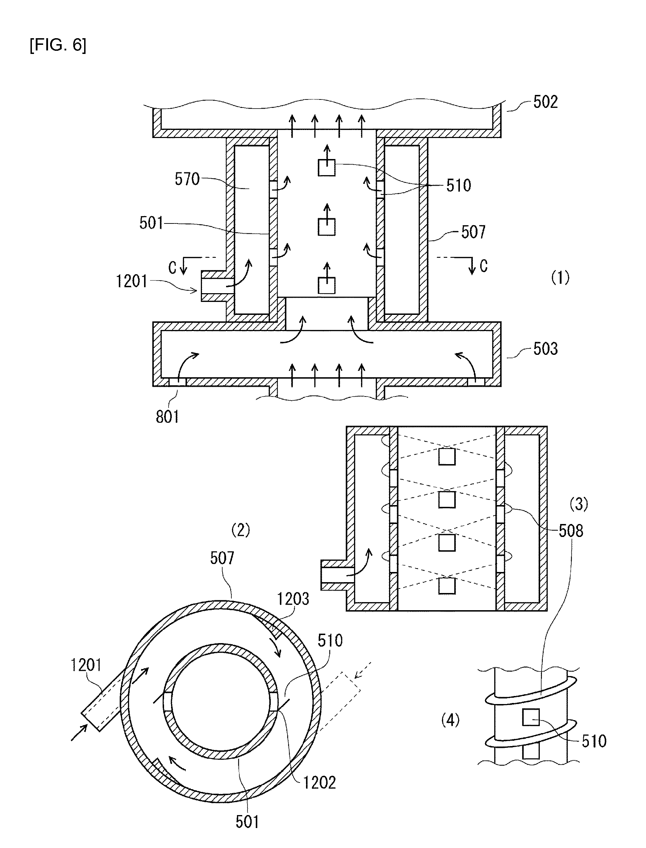

As illustrated in (1) and (2) of FIG. 6, providing a cover (507) around the combustion furnace (501) is effective to form a spiral flow.

In this embodiment, because small holes (510) are arranged staggered to one another, a spiral flow is generated along a corridor (570) formed therein, and the combustion efficiency is increased by being mixed together. Cooling of the furnace is designed by forming a flow between the flame and an inner wall of the combustion furnace (501) as well as in a space of the cover (507) and the outer wall of the combustion furnace (501) by air introduced from the inlet so that the durability of the furnace is increased.

That is, using a cover (507), the combustion efficiency is increased by allowing air and combustion gas that circulates outside the flame to be efficiently mixed by providing the cover having a plurality of inlets (1201) on the side surface of the cylindrical body of the combustion furnace (501) to cover the outer side so as to form a space and create the air flow within the device, and by supplying air spirally from the side surface against the flame.

In this case, the external air is let in from inlets (1201). The air is let in by the generation of negative pressure by the rising flame and combustion gas and enters into the combustion furnace (501) from the small holes (510). In this case, a spiral flow is formed by arranging small holes staggered to one another. A plurality of inlets (1201) may be provided according to the size of the combustion furnace (501), and also a blower or the like may be connected to the inlets (1201).

In order to form a spiral flow even more, arranging the inlet (1201) in the circumferential direction as illustrated in (2) of FIG. 6 that is a cross-section C-C of (1) in FIG. 6 allows turning power to naturally be provided. This inlet (1201) may be provided in plurality according to a condition as described above. It may be understood that air intake becomes easy by providing a guide (1202) near the inlet port of the small hole (510) so as to cover the opening as illustrated in (2) of FIG. 6.

Furthermore, when a throttle (1203) is provided along a travel path of a corridor (570), particularly arranged near the small hole, inflow can be even easier through the small hole (510).

It is also understood even more spiral flow can be obtained by providing spiral steps along the small holes (510) within the corridor (570) so as to guide the spiral steps to the upper part of the opening of the small holes as illustrated in (3) and (4) of FIG. 6.

Further, because the lower the spiral steps, the easier it is to let air in, it may be effective to have a narrower width the lower it gets, and have a wider width as it moves higher.

The partition plate (520) that is made of a material which can be red hot is overheated by the rising flame to prevent reduction of the combustion temperature, and while the flame rising up in the center of the furnace is retained by providing a plurality of openings (701) in the outside of the partition plate (520), the combustion is reinforced when combustion gas passes through the small holes (701) at a high temperature.

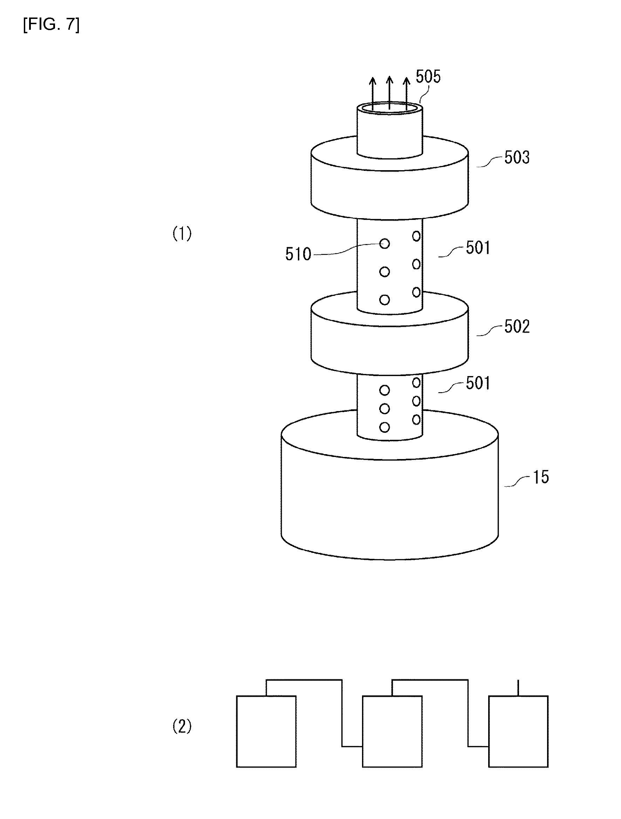

Alternately overlaying the plurality of combustion furnaces (501) and the plurality of combustion furnaces (502) enables a structure to be built that can continually supply air until combustion gas is burned out, and expanding the combustion area in the perpendicular direction by repeatedly operating the function of each combustion furnace continually enables durability to be increased. As illustrated in (2) of FIG. 7, a multistage arrangement may be allowed by connecting as a series.

By using negative pressure generated by the ascending airflow to introduce air, there is no need for new power and it realizes energy saving using natural air intake.

As long as the combustion furnace (501) has a function to create spiral airflow so as to supply air from outside of flame, its shape may be any form. However, it is apparent that it is easier to form a spiral flow when the cross-section is a circular shape.

As for the combustion furnace (502), as long as it has a function to supply air from below for combustion gas that circulates outside of the flame within the furnace, the shape may be in a form of a circle, square, polygon, or other shape.

As for the small holes, the shape, number, size, arrangement, or the like may be provided according to the need so as to be suitable for combustion.

The combustion device of a natural air intake system of the present invention is not limited to the embodiments described above, and various modifications are possible by those skilled in the art within the scope of the technical concept of the present invention. The combustion furnace, partition plate, outlet, flame through port, shape of small holes, material, scale, arrangement, and the like are matters of design, and other shapes, materials, scales, and arrangements are within the scope of the technical concept of the present invention and do not depart from it.

Next, a description of a configuration combining a drying device and the combustion device according to the present invention and a configuration of an electric power generating device using the combustion device will be given.

A thermoelectric power generation device is configured having a cylindrical combustion chamber (601) forming one portion of the side surface by a thermoelectric power generation module provided with an electric output terminal (601 k) and a plurality of thermoelectric conversion elements (601 c) that are formed in a continuous manner respectively on the opposing surface of the inside a receptor formed by a material with electrical insulating properties in order to generate thermoelectric power by the temperature difference.

A cylindrical air injection tube (601 e) where a plurality of holes (601 g) that is communicated by a blower (601 m) and a duct (601) on the inner side surface of the combustion chamber (601) is provided along the advancing direction of the flames in order to create an airflow within the combustion chamber (601).

Further, a wind directional plate (601f) is provided along the air injection tube (601 e) near the hole (601 g) of the air injection tube (610e) in order to rotate the airflow within the combustion chamber towards the axial direction.

Furthermore, a red hot plate (601 i) having a plurality of holes (601j) within the combustion chamber is provided in order to prevent reduction of the combustion temperature. A pipe shaped inlet (601 a) that also serves as an ignition port provided with an airflow injection nozzle (601 b) in order to create an induced airflow for introducing fuel into the combustion chamber and an exhaust flame cylinder (601 d) that communicates to secondary combustion (603) through a boiler (604) that creates steam using exhaust heat of the combustion chamber are provided.

A cylindrical secondary combustion chamber (602) provided with a plurality of holes (602a) in staggered arrangement on the side surface and a wide diameter secondary combustion chamber (603) having an exhaust port (603c) and provided with a red hot plate (603a) having a plurality of holes (603b) at the bottom surface and having a plurality of holes (603b) are communicated in front of the direction of the advancing flames, and a cylindrical cover (602b) having an air supply port (602c) is provided outside of the cylindrical secondary combustion chamber (602).

A boiler (604) is communicated to a steam turbine electric power generating device (605) via a steam pipe (604a), the steam turbine (605) is communicated to a heat exchanger (606) having a waste steam pipe (606a) via the steam pipe (605a), and also the heat exchanger (606) communicates with the duct (606b).

A blower (608m) that communicates with an airflow injection nozzle (601 b) via a duct (6081), links to a conveying device (607a) via a cutting machine (607), and links to the heat exchanger (606) via the duct (606b), a circulation duct (608k) provided with an airflow injection nozzle (608i) so as to create an induced airflow in the outside of the airflow to the inner wall of the winding section and in the lower part of the inner wall near the joint portion between a discharge pipe (608h) and the circulation duct (608k), an airflow drying device provided with a rotary center shaft (608d) having a fan blade (608b) and a rotary outer shaft (608c) where a plate (608g) is obliquely installed so as to cover from above an air flow injection tube (608e) having a plurality of holes (608f) and the holes (608f) of the air injection tube (608e) near the tank, a heat pump (608) where an airflow injection tube (608e) provided with a plurality of holes (608f) near a tank connecting to a motor (608a), and a heat pump(608) where a channel between a heat absorbing portion (609b) and an expansion valve (609d) of the heat pump (608) is provided to the outside of the combustion chamber (601), and a heat sink (609a) adjacent to the blower (608m) are provided in a drying tank (608) equipped with a cyclone (608) communicating with the conveying device (607a).

Solid fuel is cut by the cutting machine (607) and injected into the airflow drying device provided with a rotary center shaft (608d) having a fan blade (608b) and rotary outer shaft where a plate (608g) is obliquely installed so as to cover from above an airflow injection tube (608e) having a plurality of holes (608f), and the holes (608f) of the air flow injection tube (608e) are near a tank connecting to a motor (608a) via the conveying device (607a), and fuel is effectively dried by increasing the area and chance to contact dried air that is blown from the blower (608m) where the heat exchanger (600) and the duct (606b) are linked in a circulation system that circulates to the conveying device from the cyclone (608j) which communicates with inside the drying tank (608) and the circulation duct (608k) providing the airflow injection nozzle (608i) so as to create an induced airflow outside the airflow to the inner wall of the winding section and in the lower part of the inner wall near the joint portion between a discharge pipe (608h) and the circulation duct (608k), the dried solid fuel is transferred to the pipe-like inlet (601 a) that also serves as the ignition port provided with the airflow injection nozzle (601 b) in order to create an induced airflow for introducing the fuel into the combustion chamber through the duct (6081) by the airflow of the drying tank (608), and injected into the combustion chamber from the inlet to be combusted.

In the combustion chamber (601) power generation is conducted simultaneously without substantially reducing thermal energy by using power generation through the thermoelectric power generation module (601 c) due to the temperature difference between the inside and outside of the combustion chamber by utilizing heat obtained by combusting the fuel, and using power generation by the steam turbine power generation device (605) that is generated in the waste heat boiler (604) due to the combustion.

Further, the efficiency of the thermoelectric power generation is increased by providing at the outside of the combustion chamber (601), the channel between the expansion valve (609d) and the heat absorbing portion (609b) of the heat pump (609).

The drying efficiency is increased by introducing dried air into the airflow drying device by the heat exchanger and the blower using the heat of the exhaust steam of the steam turbine (605).

The combustion efficiency is increased by warming the combustion air by having the heat sink (609a) of the heat pump adjacent to the blower.

A description of a further different embodiment for the structure of the combustion device according to the present invention will be given.

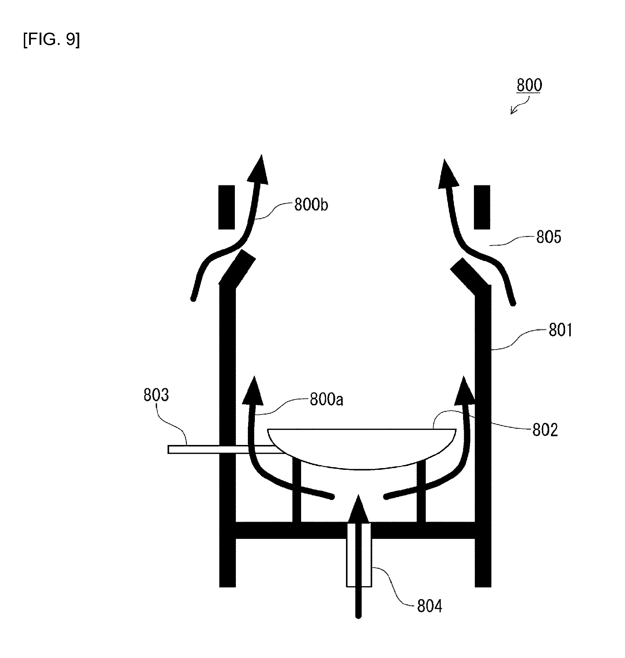

A combustion device (800) in FIG. 9 is an embodiment when combining forced air supply and natural air intake as an air intake method in a combustion chamber.

A combustion tray (802) with a raised level using legs is arranged within a combustion chamber (801), and fuel is fed to the combustion tray through a feed oil tube (803). An air blowing port (804) is arranged at the bottom part of the combustion chamber (801) to blow air or the like from below to the bottom surface side of the combustion tray (802).

In this case, blown air (800a) becomes a straight airflow advancing upwardly along the inner circumference of the combustion chamber (801) according to the shape of the bottom surface of the combustion tray (802), and air can be supplied from outside of the flame of the combustion tray (802).

Further, natural air intake (800b) is carried out from the periphery through a natural air intake port (805) that is on an upper part of the combustion chamber (801) to contribute to air supply from outside of the flames as with the straight airflow.

According to the present method, because the straight airflow along the inner circumference of the combustion chamber (801) extends the grate in the frame advancing direction and allows for continuous air supply, similar effects are exhibited as in the embodiments described above.

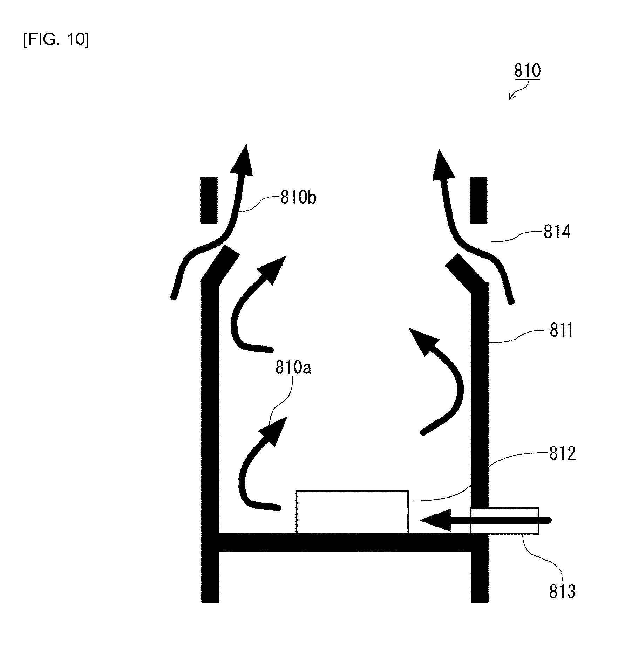

A combustion device (810) in FIG. 10 is also an embodiment when combining forced air supply and natural air intake as an air intake method in a combustion chamber.

A combustion tray (812) is arranged at the bottom part of the combustion chamber (811), and an air blowing port (813) is arranged in the lower end part of the side surface of the combustion chamber (801) so as to blow air along the inner circumferential surface of the combustion chamber (801).

In this case, a swirling airflow (810a) where air advances upward while swirling between the combustion tray (812) and the combustion chamber (811) is generated and air can be supplied from outside of the flame of the combustion tray (812).

Further, natural air intake (810b) is carried out from the periphery through a natural air intake port (814) that is on an upper part of the combustion chamber (811) to contribute to air supply from the outside of the flame as with the swirling airflow. The present invention can also obtain similar advantageous effects as those described above.

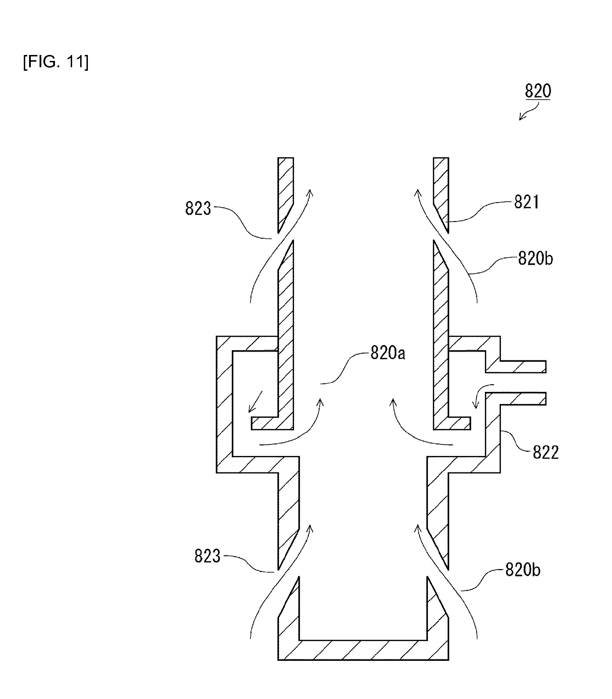

A combustion device (820) in FIG. 11 is also an embodiment when combining forced air supply and natural air intake as an air intake method in a combustion chamber.

An air blowing port (822) is arranged in the middle section on the side surface of a combustion chamber (821) so as to blow a straight airflow (820a) of stable air volume and direction along the inner circumferential surface of the combustion chamber (821) by wrapping around the airflow within the air blowing port.

Further, natural air intake (820b) is carried out from the periphery through natural air intake ports (823) and (824) that are on lower and upper parts of the combustion chamber (821) to contribute to air supply from the outside of the flame as with the swirling airflow. The present invention can also obtain similar advantageous effects as those described above.

As described above, the combustion device and the drying device can be combined for use in the present invention, and known various systems may be used for the drying device.

For example, in a method in which an object to be dried is blown upward from the lower part to the upper part by blowing air within a duct, a nozzle is arranged downstream of the air blowing from the blower, and heat, hot air, and the like that are generated in the combustion device are taken into the duct. A nozzle is further arranged in a latter step to introduce the drying object. Accordingly, warm air and hot air generated in the combustion device can be efficiently used, and also using the nozzle in the latter step can prevent the motor from heating.

It may be a drying device of a rotary kiln type that heats while rotating the kiln. This case also blows a drying object upward from the lower part to the upper part by blowing air within the duct of the kiln to circulate. The drying object is removed by sucking up with a vacuum.

In using a pan type dryer, using a function to mix and move by providing a rotary blade and a rotating shaft in a cylindrical drying tank supplies a determinate quantity. Drying is promoted by applying heat from the bottom and side surfaces.

Finally, a structure of a combustion chamber that enables solid fuel to be introduced is described. Conventionally, there has been a problem in having difficulty introducing solid combustion material due to the attraction of flames into the inlet due to negative pressure when an inlet for introducing solid combustion material is opened. Therefore, even though liquid fuel can be combusted in the conventional technology described above, there has been no proposed design for a configuration to combust solid fuel.

The present invention provides a configuration where a combustion material can be introduced safely and simply by relatively diminishing the negative pressure in the inlet by generating airflow in a specified direction within a combustion chamber in order to at least combust the combustion material containing solid content.

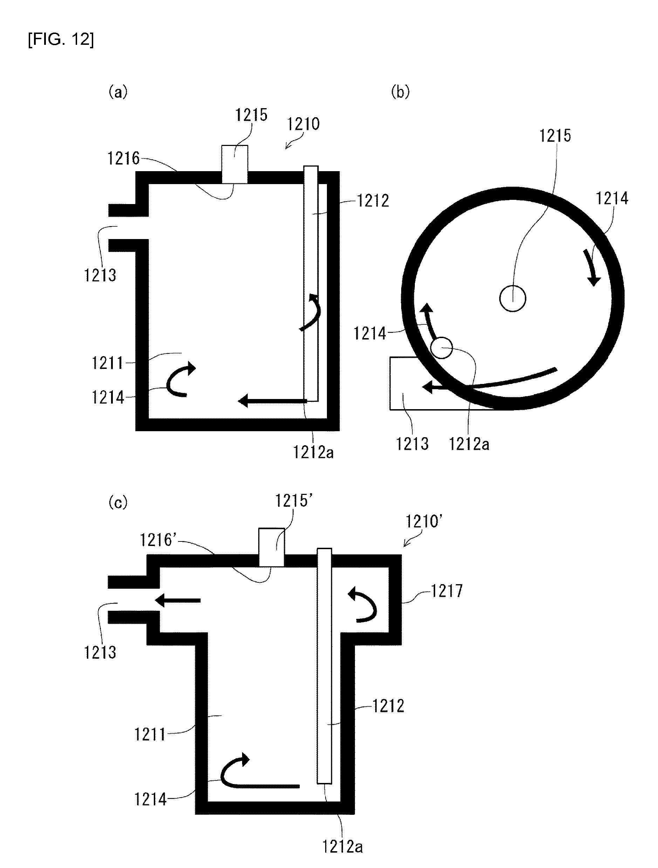

FIG. 12 illustrates a side view (a) and plan view (b) of a combustion device (1210) where combustion material is introduced from the top surface (plane side) of a combustion chamber, and a side view (c) of another embodiment.

A tip nozzle (1212a) for an air injection tube (1212) is arranged near the lower side surface of a combustion chamber (1211), and also an exhaust port (1213) is provided on the upper side surface to supply air or the like from outside of the flame. At that time, the air from the air injection tube forms airflow (1214) swirling in the inner circumference of the combustion chamber (1211).

Therefore, the flames in the combustion chamber becomes a state of being constantly attracted to the exhaust port side due to the swirling airflow from the air injection tube tip towards the exhaust port so that there is no risk of spurting flames from the inlet side even when opening the inlet (1215) to introduce combustion material, and accordingly combustion material containing solid content is allowed to be safely introduced.

The combustion material introduced from the inlet (1215) is directly dropped toward the flames from each discharge port (1216).

In a combustion device (1210') illustrated in FIG. 12 (b) of another embodiment, a large diameter section (1217) is formed in an upper part of the combustion chamber, and by rotating the swirling airflow (1214) from the air injection nozzle tip end (1212a) to the outer circumference in the large diameter section (1217), the flames are attracted to the outer circumference. The configuration in this manner enables the combustion materials to be safely introduced even when arranging a discharge port (1216') vertically below the inlet (1215') in the center part.

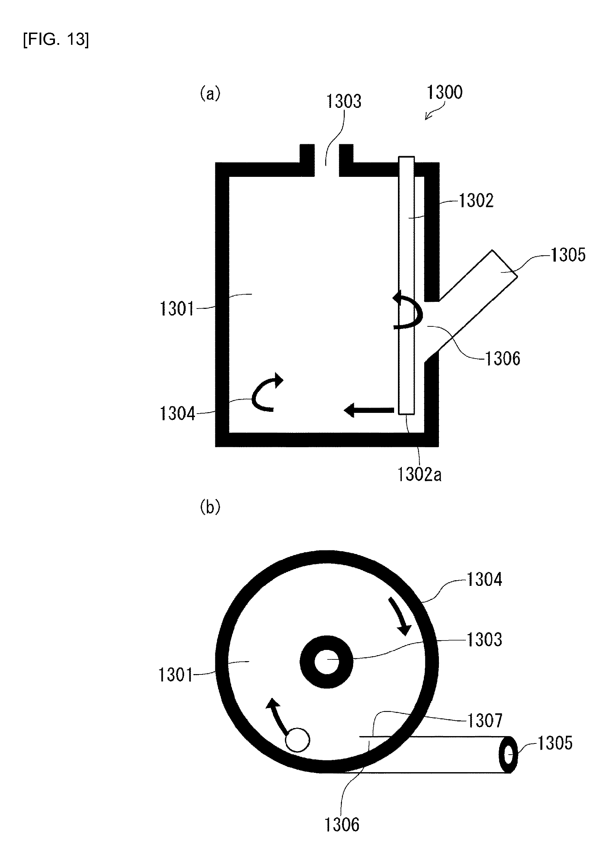

FIG. 13 illustrates a side view (a) and a plan view (b) of a combustion device (1300) where combustion material is introduced from the side surface of the combustion chamber.

A tip nozzle (1302a) for an air injection tube (1302) is arranged near the lower side surface of a combustion chamber (1301), and also an exhaust port (1303) is provided on the upper top surface to supply air or the like from the outside of the flame. At that time, the air from the air injection tube is swirled in the inner circumference of a combustion chamber (1301) and the formed airflow (1304) reaches to the top surface thereafter.

Further, an inlet (1305) for introducing combustion material is arranged in the middle position of the outer peripheral side surface of a combustion chamber (1301). Because the discharge port (1306) faces along the airflow from the air injection tube (1302) as seen in the plan view (b), there is no ejecting flame from the inlet (1305) so that safe introduction can be carried out.

Furthermore, the configuration is made by arranging a wind direction plate (1307) which extends the discharge port (1306) along the airflow so that the flame not attracted to the inlet.

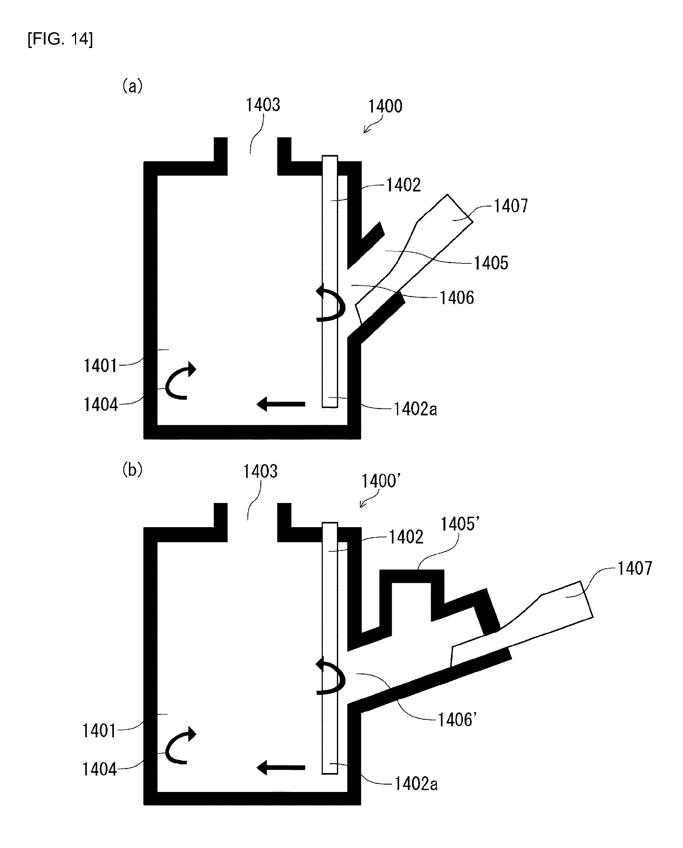

FIG. 14 illustrates another embodiment of a combustion device (1400) where a combustion material is introduced from the side surface.

In FIG. 14 (a), a tip nozzle (1402a) for an air injection tube (1402) is arranged near the lower side surface of a combustion chamber (1401), and also an exhaust port (1403) is provided on the upper top surface to supply air or the like from the outside of the flame. At that time, the air from the air injection tube is swirled in the inner circumference of a combustion chamber (1401) and the formed airflow (1404) reaches to the top surface thereafter.

Further, an inlet (1405) for introducing a combustion material is arranged in the middle position of the outer peripheral side surface of a combustion chamber (1401), and also an air injection nozzle (1407) is arranged in the same opening section.

According to the present configuration, combustion materials can be safely introduced without attracting the flame into the discharge port (1406) due to wind pressure from the air injection nozzle (1407) and the swirling airflow from the air injection tube.

FIG. 14 (b) is a combustion device (1400') of even another embodiment, and an inlet (1405') faces the upper surface side. The present configuration also allows safe introduction without attracting the flame into the discharge port (1406') due to wind pressure from the air injection nozzle (1407) as well.

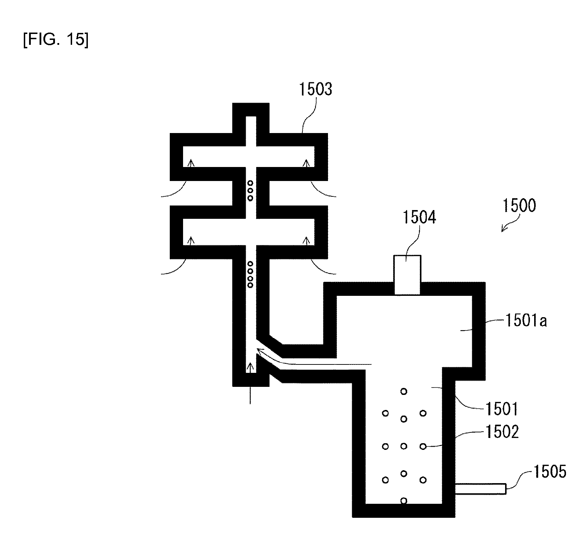

FIG. 15 illustrates a configuration where a secondary combustion device (1503) is additionally provided to the combustion device (1500). The secondary combustion device is a similar configuration to that disclosed in FIG. 5 described above. Because columns of a large number of holes (1502) are provided on the side surface of the combustion chamber (1501), spiral airflow is generated in the furnace to enhance contact efficiency of the air with the combustion gas rising with the flames from the outside, and a swirling radius in the upper large diameter section (1501 a) is increased.

Combustion material can be safely introduced from the inlet (1504) of the top surface to the large diameter section (1501 a). That is, strong air intake is generated towards the secondary combustion device in the present device, and therefore the combustion material is completely combusted in the combustion chamber (1501) and the combustion furnace of the secondary combustion device (1503) without spurting flames from the inlet (4).

A feed oil tube (1505) for feeding fuel is provided in the lower end section of the combustion chamber (1501).

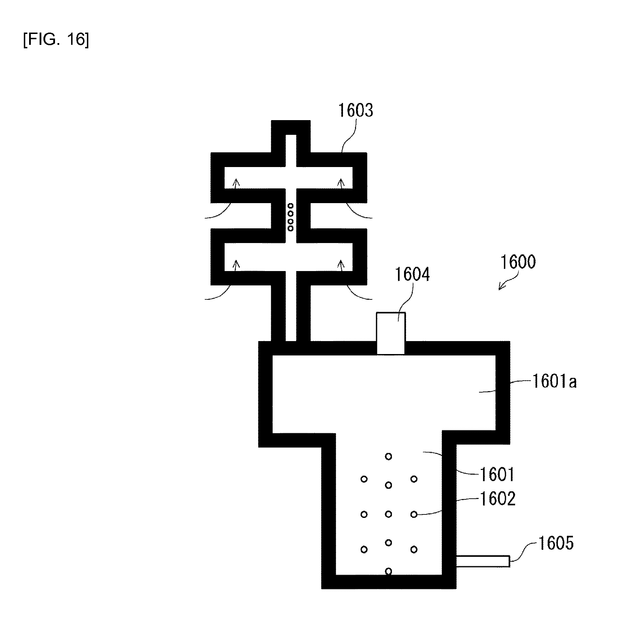

FIG. 16 illustrates another embodiment that additionally provides a secondary combustion device (1603) to the combustion device (1600). In the same manner as described above, because columns of a large number of holes (1602) are provided on the side surface of the combustion chamber (1601), a spiral airflow is generated in the furnace to enhance contact efficiency of the air with the combustion gas rising with the flames from the outside, and a swirling radius in the upper large diameter section (1601 a) is increased.

Therefore, the secondary combustion device (1603) may be provided directly onto the top surface of the large diameter section (1601 a) as in the present embodiment. Combustion material can be safely introduced from the inlet (1604) of the top surface because the airflow swirls in the outer circumference of the large diameter section (1601a).

A feed oil tube (1605) for feeding fuel is provided in the lower end section of the combustion chamber (1601).

### Explanation of the Reference Codes

- 601: combustion device
- 601a: inlet
- 601b: airflow injection nozzle
- 601c: thermoelectric conversion elements
- 601d: exhaust smoke tube
- 601e: air injection tube
- 601f: wind directional plate
- 601g: hole
- 601i: red hot plate
- 601j: hole
- 601k: electrical output terminal
- 601l: duct
- 601m: blower
- 602: secondary combustion chamber
- 602a: hole
- 602b: cover
- 602c: air supply opening
- 603: wide diameter secondary combustion chamber
- 603a: partition plate
- 603b: hole
- 603c: exhaust pipe
- 604: boiler
- 604a: steam pipe
- 605: steam turbine electric power generating device
- 605a: steam pipe
- 606: heat exchanger
- 606a: waste steam pipe
- 606b: duct
- 607: cutting machine
- 607a: conveying device
- 608: airflow drying device
- 608a: monitor
- 608b: fan blade
- 608c: rotary outer shaft
- 608d: rotary center shaft
- 608e: air injection tube
- 608f: hole
- 608g: plate
- 608h: discharge pipe
- 608i: airflow injection nozzle
- 608j: cyclone
- 608k: circulation duct
- 6081: duct
- 608m: blower
- 609: heat pump
- 609a: heat sink
- 609b: heat absorbing portion
- 609c: compression machine
- 609d: expansion valve

## Claims

1. A combustion method for burning combustion material in a combustion chamber comprising:
a step for introducing the combustion material into the combustion chamber of a combustion device,
a step for burning by igniting the combustion material,
a step for supplying air or a combustion-aiding gas (referred to hereinafter as "air or the like") from outside a flame to the flame in conjunction with combustion of the combustion material,
a step for a secondary combustion of the combustion material by the air or the like, and
a step for smoke exhaustion.

2. The combustion method according to claim 1, comprising
a step for additionally introducing the combustion material that includes at least a solid content into the combustion chamber
during combustion of the combustion material in the combustion method.

3. The combustion method according to claim 2, wherein
an induced airflow is generated in the combustion chamber in the step for additionally introducing the combustion material in the combustion method.

4. The combustion method according to claim 3, wherein
the induced airflow is configured to swirl in the combustion chamber so as to cause smoke exhaustion from smoke exhaustion means provided in a cyclone shape in the advancing direction of the airflow in the step for smoke exhaustion.

5. The combustion method according to any of claims 1 to 4, comprising,
in the step for a secondary combustion of the combustion material,
a step for supplying air or the like to a flame from the rear of the advancing direction of the flame.

6. The combustion method according to any of claim 5, wherein,
in the combustion method,
a step for supplying air or the like to the flame from the outside, and
a step for supplying air or the like to the flame from the rear of the advancing direction of the flame is alternately repeated.

7. The combustion method according to any of claims 1 to 6, wherein,
in the combustion method,
advancing of the flame is controlled by a partition having a flame through means relative to a progressing flame.

8. The combustion method according to any of claims 1 to 7, wherein,
the combustion method is a configuration that dries the combustion material including at least a solid content prior to combustion, comprising
a step for transporting the combustion material to a deposit location,
a step for transporting the deposited combustion material from a lower part of the deposit location to an upper part of the deposit location,
a step for drying the combustion material at the deposit location and in the transport process,
and a step for recovering the dried combustion material and transporting to a combustion chamber.

9. The combustion material according to claim 8, wherein
the step for transporting from a lower part to an upper part of the deposit location is a configuration that uses air or the like to blow the combustion material upward so as to generate an induced airflow to the outside of the upward blown airflow.

10. The combustion method according to claim 8 or 9, wherein,
in the step for recovering the dried combustion material and transporting to a combustion chamber, exhaust is also recovered and the exhaust is supplied to a combustion device as air for combustion.

11. A power-generating method, using the combustion method according to any of claims 1 to 9, that forms a part or all of a combustion device by a thermoelectric power generation module, and utilizes a temperature difference between the inside and outside of the combustion device generated in the combustion process.

12. A combustion device for burning combustion material comprising
a combustion chamber formed in a cylinder shape and an air supply opening provided on the inner side surface of the combustion chamber, the combustion device including cylindrical air injection tubes provided with holes on the inner surface in the advancing direction of a flame.

13. The combustion device according to claim 12, comprising a partition provided with flame through means inside the combustion chamber.

14. The combustion device according to claim 12 or 13, comprising
the combustion material inlet configured of a pipe on the side surface of the combustion chamber, and an airflow injection nozzle so as to generate an induced airflow on the inner wall of the pipe.

15. The combustion device according to any of claims 12 to 14, wherein
smoke exhaustion means is provided in the combustion chamber, and the smoke exhaustion means is provided in a cyclone shape in the advancing direction of the circulating airflow.

16. The combustion device according to any of claims 12 to 15, comprising
a secondary combustion chamber of a cylindrical body provided with holes in the side surface having means to incorporate continuous flames in the combustion chamber.

17. The combustion device according to claim 16, comprising
means to incorporate the secondary combustion chamber with air or combustion-aiding gas (hereinafter referred to as "air or the like") from the rear of the advancing direction of flames communicating with the secondary combustion chamber.

18. The combustion device according to claim 16 or 17, comprising,
in the secondary combustion chamber, at least two types of secondary combustion chambers with different diameters.

19. The combustion device according to any of claims 16 to 19, comprising,
in the secondary combustion chamber, a cover having a cylindrical body covering the outside to form a space having means to take in air.

20. The combustion device according to any of claims 16 to 19, wherein
a dried object outlet of a drying device provided with a deposition tank having an object to be dried inlet, a circulation inlet, an object to be dried outlet, a dried object outlet, and means for circulating transport from the object to be dried outlet to the circulation inlet, is connected to a combustion inlet of the combustion device.

21. The combustion device according to claim 20, wherein
a rotary shaft is provided on a drying tank of the drying device, an injection tube provided with holes that promote stirring is provided near the drying tank of the rotary shaft, plates are obliquely disposed so as to cover the holes from above the holes of the injection tube, and means for supplying pressure air or the like is provided on the injection tube.

22. The combustion device according to claim 21, wherein
the means for supplying pressure air provides fan blades driven by a rotary shaft to supply air or the like pressurized by the fan blades into the injection tube.

23. The combustion device according to claim 22, wherein
the rotary shaft is divided into an outer shaft and a center shaft and stirring blades, the injection tube, and the plates are provided on the outer shaft, and fan blades are provided on the center shaft.

24. The combustion device according to any of claims 20 to 23, wherein the drying device is a configuration in which the object to be dried outlet and the circulation inlet communicate via a circulation duct equipped with blower means, and the circulation duct is provided with an airflow injection nozzle, having supply means of compressed air so as to generate an induced airflow to the outside of the airflow, on the inlet bottom inner wall and curved inner wall of the circulation duct.

25. The combustion device according to any of claims 21 to 24, wherein
a route from an expansion valve of a heat pump to a heat absorbing portion on the outside of the combustion chamber is provided that supplies exhaust heat of the heat pump to the injection tube of air or the like of the combustion chamber by a blower.

26. The combustion device according to claim 24 or 25, comprising an exhaust heat boiler that generates steam using exhaust heat of the combustion chamber and a steam turbine that operates using steam generated by the exhaust heat boiler, wherein a heat exchanger is provided that uses the exhaust heat of the steam discharged from the steam turbine, and warm air or hot air supplied from the heat exchanger is incorporated into the circulation duct.

27. An electric power-generating device that uses the combustion device according to any of claims 12 to 26, comprised in part or all by a thermoelectric power generation module provided with a plurality of thermoelectric conversion elements continuously formed respectively on opposing surfaces of an inner side of a receptor formed of a material having electrical insulating properties, and that generate electricity by the temperature difference generated at each end.

28. An electric power-generating system, comprising a combustion device provided with a combustible solid waste cutting machine, an airflow drying device for combustible solid waste, and a secondary combustion device that uses combustible solid waste as fuel, and an electric power-generating device provided with an exhaust heat boiler that uses exhaust heat of the combustion device, a steam turbine electric power generator, and a heat pump; the electric power-generating system forming part or all of the combustion device by a thermoelectric power generation module and effectively using a same heat source for thermoelectric and steam turbine power generators.
